# EUROPÄISCHE PATENTSCHRIFT

(11) **EP 2 330 650 B1**
(45) Veröffentlichungstag und Bekanntmachung des Hinweises auf die Patenterteilung: **03.10.2012**
(21) Anmeldenummer: 10192847.1
(22) Anmeldetag: 29.11.2010
(51) Int. Cl.: H01L 41/193, H01L 41/26, C08G 18/00, C08G 18/48

(54) **Elektromechanischer Wandler, umfassend ein Polyurethanpolymer mit Polytetramethylenglykolether-Einheiten**
Electromechanical converter comprising a polyurethane polymer with polytetramethyleneglycol ether units
Convertisseur électromécanique comprenant un polymère de polyuréthane doté d'unités d'éther de poly-tétra-méthylène-glycol

(30) Priorität: 04.12.2009 EP 09015051
(43) Veröffentlichungstag der Anmeldung: 08.06.2011
(73) Patentinhaber: Bayer MaterialScience AG, 51368 Leverkusen (DE)
(72) Erfinder: Jenninger, Werner, Köln 50677 (DE); Dörr, Sebastian, 40597 Düsseldorf (DE); Wagner, Joachim, 51061 Köln (DE); Peiffer, Evelyn, 51375 Leverkusen (DE); Vogel, Stephanie, 40764 Langenfeld (DE); Nefzger, Hartmut, 50259 Pulheim (DE); Schmidt, Manfred, 41540 Dormagen (DE)

(56) Entgegenhaltungen:
- WO-A1-01/06575
- US-A- 5 977 685
- US-A1- 2009 154 053

## Beschreibung

Die vorliegende Erfindung betrifft einen elektromechanischen Wandler, umfassend ein durch eine erste Elektrode und eine zweite Elektrode kontaktiertes dielektrisches Elastomer, wobei das dielektrische Elastomer ein Polyurethanpolymer umfasst. Das Polyurethanpolymer umfasst hierbei mindestens eine Polytetramethylenglykolether-Einheit. Die Erfindung betrifft weiterhin ein Verfahren zur Herstellung eines solchen elektromechanischen Wandlers, die Verwendung des eingesetzten dielektrischen Elastomers sowie eine elektrische und/oder elektronische Vorrichtung, umfassend einen erfindungsgemäßen elektromechanischen Wandler.

Elektromechanische Wandler spielen eine wichtige Rolle bei der Umwandlung von elektrischer Energie in mechanische Energie und umgekehrt. Elektromechanische Wandler können daher als Sensoren, Aktuatoren und/oder Generatoren eingesetzt werden.

Eine Klasse von solchen Wandlern basiert auf elektroaktiven Polymeren. Es ist ein ständiges Ziel, die Eigenschaften der elektroaktiven Polymere, insbesondere den elektrischen Widerstand und die Durchbruchfestigkeit, zu erhöhen. Gleichzeitig soll aber die Mechanik der Polymere sie für Einsätze in elektromechanischen Wandlern geeignet machen.

Eine Möglichkeit der Erhöhung der Dielektrizitätskonstante ist die Zugabe von bestimmten Füllstoffen. So beschreibt WO 2008/095621 Rußgefüllte Polyurethanmassen, die wenigstens bestehen aus Polyetherurethanen, in die Polyolkomponenten eingebaut sind, die zu 50-100 Gew.-% aus durch DMC-Katalyse hergestellten Polyalkylenoxiden, insbesondere Polypropylenoxiden, und 0-50 Gew.-% aus von Katalysatorresten freien Polyolen, insbesondere solchen, die destillativ oder durch Umkristallisation gereinigt sind, oder solchen, die nicht durch ringöffnende Polymerisation von Sauerstoffheterocyclen hergestellt wurden, aufgebaut sind. Weiterhin enthalten die Polyurethanmassen 0,1-30 Gew.-% Ruß.

Energiewandler aus filmbildenden wässrigen Polyurethandispersionen werden in WO 2009/074192 offenbart. Auch hier werden die hohen Dielektrizitätskonstanten und die guten mechanischen Eigenschaften der erhaltenen Polyurethanfilme hervorgehoben.

Es besteht jedoch weiterhin der Bedarf an elektromechanischen Wandlern mit dielektrischen Elastomeren, die gleichzeitig hohe elektrische Widerstände und hohe Durchbruchfeldstärken aufweisen, um noch höhere Wirkungsgrade der Wandler zu erreichen.

Erfindungsgemäß vorgeschlagen wird daher ein elektromechanischer Wandler, umfassend ein durch eine erste Elektrode und eine zweite Elektrode kontaktiertes dielektrisches Elastomer, wobei das dielektrische Elastomer ein Polyurethanpolymer umfasst. Der erfindungsgemäße Wandler zeichnet sich dadurch aus, dass das Polyurethanpolymer erhältlich ist aus der Reaktion von
A) einem Polyisocyanat und/oder B) einem Polyisocyanat-Prepolymer
mit C) einer Verbindung mit mindestens zwei isocyanatreaktiven Gruppen;
wobei das Polyisocyanat-Prepolymer B) und/oder die Verbindung mit mindestens zwei isocyanatreaktiven Gruppen C) Polytetramethylenglykolether-Einheiten der allgemeinen Formel (I) umfassen:

=[O=CH₂=CH₂=CH₂=CH₂=]ₙ (I)

mit n ≥ 25; und
mit einem Minimalwert ⁿmin für den Wert n und einem Maximalwert nₘₐₓ für den Wert n in der allgemeinen Formel (I);
wobei die Differenz zwischen nₘₐₓ und ⁿmin ≥ bis ≤ 4 beträgt;
wobei für den Fall, dass das Polyisocyanat-Prepolymer B) und die Verbindung mit mindestens zwei isocyanatreaktiven Gruppen C) Polytetramethylenglykolether-Einheiten der allgemeinen Formel (I) umfassen, die Werte n, nₘₐₓ und nₘᵢₙ bezüglich des Polyisocyanat-Prepolymers B) einerseits und der Verbindung mit mindestens zwei isocyanatreaktiven Gruppen C) andererseits gleich oder verschieden sein können; und
wobei in dem Polyisocyanat-Prepolymer B) und in der Verbindung mit mindestens zwei isocyanatreaktiven Gruppen C) jeweils für sich gesehen keine weiteren Polytetramethylenglykolether-Einheiten neben denjenigen der allgemeinen Formel (I) vorhanden sind.

Es wurde gefunden, dass die im erfindungsgemäßen elektromechanischen Wandler vorgesehenen Polyurethanpolymere besonders hohe elektrische Widerstände in Verbindung mit hohen Durchbruchfeldstärken aufweisen. Gleichzeitig liegen die Polyurethane als weiche Elastomere vor. Die Kombination dieser Eigenschaften ergibt einen vorteilhaften Einsatz in elektromechanischen Wandlern.

Wenn eine mechanische Beanspruchung auf einen derartigen Wandler ausgeübt wird, so deformiert sich der Wandler beispielsweise entlang seiner Dicke und seiner Fläche und ein starkes elektrisches Signal kann an den Elektroden detektiert werden. Damit wird mechanische Energie in elektrische Energie umgewandelt. Der erfindungsgemäße Wandler kann folglich sowohl als Generator als auch als Sensor eingesetzt werden.

Unter Ausnutzung des entgegengesetzten Effekts, nämlich der Umwandlung von elektrischer Energie in mechanische Energie, kann der erfindungsgemäße Wandler andererseits gleichermaßen als Aktuator dienen.

Als Elektroden sind grundsätzlich alle Materialien geeignet, welche eine ausreichen hohe elektrische Leitfähigkeit aufweisen und vorteilhafterweise der Ausdehnung des dielektrischen Elastomers folgen können. Beispielsweise können die Elektroden aus einem elektrisch leitfähigen Polymer, aus Leittinte oder aus Ruß aufgebaut sein.

Dielektrische Elastomere im Sinne der vorliegenden Erfindung sind Elastomere, die ihre Form durch das Anlegen eines elektrischen Feldes ändern können. Im Fall von Elastomerfolien kann sich zum Beispiel die Dicke verringern, während es gleichzeitig zu einer Längenausdehnung der Folie in Flächenrichtung kommt.

Die Dicke der dielektrischen Elastomerschicht beträgt vorzugsweise ≥ 1 µm bis < 500 µm und mehr bevorzugt ≥ 10 µm bis ≤ 100 µm. Sie kann einstückig oder mehrstückig aufgebaut sein. Beispielsweise kann eine mehrstückige Schicht durch Aufeinanderlaminieren von einzelnen Schichten erhalten werden.

Das dielektrische Elastomer kann neben dem erfindungsgemäß vorgesehenen Polyurethanpolymer noch weitere Inhaltsstoffe aufweisen. Solche Inhaltsstoffe sind beispielsweise Vernetzer, Verdicker, Colösemittel, Thixotropiermittel, Stabilisatoren, Antioxidantien, Lichtschutzmittel, Emulgatoren, Tenside, Klebstoffe, Weichmacher, Hydrophobierungsmittel, Pigmente, Füllstoffe und Verlaufshilfsmittel.

Füllstoffe im Elastomer können beispielsweise die Dielektrizitätskonstante des Polymers regulieren. Beispiele hierfür sind keramische Füllstoffe, insbesondere Bariumtitanat, Titandioxid und piezoelektrische Keramiken wie Quarz oder Bleizirkoniumtitanat, sowie organische Füllstoffe, insbesondere solche mit einer hohen elektrischen Polarisierbarkeit, beispielsweise Phthalocyanine.

Außerdem ist eine hohe Dielektrizitätskonstante auch durch das Einbringen elektrisch leitfähiger Füllstoffe unterhalb ihrer Perkolationsschwelle erzielbar. Beispiele hierfür sind Ruß, Graphit, einwandige oder mehrwandige Kohlenstoff-Nanoröhrchen, elektrisch leitfähige Polymere wie Polythiophene, Polyaniline oder Polypyrrole, oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen.

Es ist vorgesehen, dass das Polyurethanpolymer erhältlich ist aus der Reaktion von einem Polyisocyanat A) und/oder einem Polyisocyanat-Prepolymer B) mit einer Verbindung C), welche mindestens zwei isocyanatreaktive Gruppen umfasst. Hierbei weisen B) und/oder C) die Polytetramethylenglykolether-Einheiten der eingangs erwähnten allgemeinen Formel (I) auf. Es ergeben sich die folgenden Möglichkeiten: A) + C) mit Einheiten (I) in C); B) + C) mit Einheiten (I) in B); B) + C) mit Einheiten (I) in C); B) + C) mit Einheiten (I) in B) und C); A) + B) + C) mit Einheiten (I) in B); A) + B) + C) mit Einheiten (I) in C) und schließlich A) + B) + C) mit Einheiten (I) in B) und C).

Die Einheiten (I) in dem Polyurethanpolymer lassen sich beispielsweise aus der Umsetzung von Polyisocyanaten und/oder Polyisocyanat-Prepolymeren mit Polyetherpolyolen erhalten, die auf polymerem Tetrahydrofuran (polymerem THF) basieren. Ebenfalls können diese Polyole auch zum Aufbau der Prepolymere verwendet werden.

Der Wert n in der allgemeinen Formel (I) gibt die Kettenlänge des polymeren THF an und korreliert so mit der Molekülmasse des eingesetzten Polyols. Hierbei beträgt der Wert n mindestens 25. Dieses entspricht einem polymeren THF mit einer Molekülmasse von etwa 1800 g/mol. Es hat sich gezeigt, dass bei deutlich geringeren mittleren Molekülmassen des polymeren THF nicht die gewünschte Kombination aus elektrischem Widerstand und Durchbruchsfeldstärke im Polyurethanpolymer erreicht wird. Der Wert n kann beispielsweise auch ≥ 27 betragen, was einer Molekülmasse von etwa 2000 g/mol entsprechen würde. Weitere bevorzugte Werte für n sind ≥ 41 oder ≥ 55.

In dem erfindungsgemäß eingesetzten Polymer wird angestrebt, dass die Kettenlängen der Einheiten (I) möglichst einheitlich sind. Dieses ist dann erfüllt, wenn die Längendifferenz zwischen der kürzesten Kette im Polymer und der längsten Kette im Polyurethanpolymer ≥ bis ≤ 4 Gruppen -[O-CH₂-CH₂-CH₂-CH₂-] beträgt. Diese Differenz zwischen nₘₐₓ und nₘᵢₙ kann auch ≤ 0 bis ≤ 3 oder ≥ 1 bis ≥ 2 betragen. Bei möglichst einheitlichen Kettenlängen lässt sich ein sehr regelmäßiges Polyurethanpolymer erhalten. Hierzu wird in einem Fall der vorliegenden Erfindung eine Ausnahme gemacht. Diese Ausnahme betrifft den Fall, dass ein Polyurethanpolymer mit den Komponenten A) + B) + C) hergestellt wird.

Dann können nicht nur die Einheiten (I) in dem Polymer, die aus dem Prepolymer B) und der Verbindung C) stammen, dieselben Werte für n, nₘₐₓ und nₘᵢₙ aufweisen. Bildlich gesprochen wurde in diesem Fall dasselbe polymere THF mit der erfindungsgemäß vorgesehenen Einheitlichkeit der Kettenlängen in B) und C) eingesetzt. Es ist aber auch vorgesehen, dass in B) und in C) unterschiedliche polymere THF-Polyole eingesetzt werden können, wenn diese jedes für sich die geforderte Einheitlichkeit der Kettenlängen aufweist. Dann weisen die Einheiten (I) in B) Werte für n, nₘₐₓ und nₘᵢₙ auf und die Differenz zwischen nₘₐₓ und nₘᵢₙ beträgt ≥ 0 bis ≤ 4, 0 bis ≤ 3 oder ≥ 1 bis ≤ 2. Einheiten (I) in C) weisen andere Werte für n, nₘₐₓ und nₘᵢₙ auf und die Differenz zwischen nₘₐₓ und nₘᵢₙ beträgt auch hier ≥ 0 bis ≤ 4, ≥ bis ≤ 3 oder ≥ 1 bis ≤ 2.

Weiterhin ist erfindungsgemäß vorgesehen, dass in dem Polyisocyanat-Prepolymer B) und in der Verbindung mit mindestens zwei isocyanatreaktiven Gruppen C) jeweils für sich gesehen keine weiteren Polytetramethylenglykolether-Einheiten neben denjenigen der allgemeinen Formel (I) vorhanden sind. Dieses bedeutet, dass in dem Prepolymer B) keine Polytetramethylenglykolether-Einheiten mit anderen Werten für n oder für die Differenz zwischen nₘₐₓ und nₘᵢₙ enthalten sind und dass in der Verbindung C) ebenfalls keine Polytetramethylenglykolether-Einheiten mit anderen Werten für n oder für die Differenz zwischen nₘₐₓ und nₘᵢₙ enthalten sind. Auch dieses trägt zu einem regelmäßigen Aufbau des Polyurethanpolymers bei.

Zum Beispiel ist es gerade nicht vorgesehen, dass zur Herstellung des Polyurethans eine Mischung zweier verschiedener polymerer THF-Polyether für das Prepolymer B) oder die Komponente C) verwendet wird. Zwar könnte eine 1:1-Mischung eines polymeren THF mit einer mittleren Molekülmasse von 1000 g/mol beziehungsweise 3000 g/mol auch eine durchschnittliche Molekülmasse von 2000 g/mol ergeben. Die Differenz zwischen der längsten Polymerkette (aus dem polymeren THF mit 3000 g/mol) und der kürzesten Polymerkette (aus dem polymeren THF mit 1000 g/mol) wäre jedoch mit Sicherheit größer als vier Gruppen -[O-CH₂-CH₂-CH₂-CH₂-].

Als Polyisocyanat und Komponente A) eignen sich erfindungsgemäß beispielsweise 1,4-Butylendiisocyanat, 1,6 Hexamethylendiisocyanat (HDI), Isophorondiisocyanat (IPDI), 2,2,4 **und/oder** 2, 4, 4-Trimethylhexamethylendiisocyanat, die isomeren Bis-(4,4' - isocyanatocyclohexyl)methane oder deren Mischungen beliebigen Isomerengehalts, 1,4-Cyclohexylendiisocyanat, 4-Isocyanatomethyl-1,8-octandiisocyanat (Nonantriisocyanat), 1,4-Phenylendiisocyanat, 2,4- und/oder 2,6-Toluylendiisocyanat, 1,5-Naphthylendiisocyanat, 2,2'- und/oder 2,4'- und/oder 4,4'-Diphenylmethandiisocyanat, 1,3- und/oder 1,4-Bis-(2-isocyanato-prop-2-yl)-benzol (TMXDI), 1,3-Bis(isocyanatomethyl)benzol (XDI), Alkyl-2,6-diisocyanatohexanoate (Lysindiisocyanate) mit Alkylgruppen mit 1 bis 8 Kohlenstoffatomen sowie Mischungen davon. Weiterhin sind Uretdion-, Isocyanurat-, Biuret-, Iminooxadiazindion- oder Oxadiazintrionstruktur enthaltende Verbindungen basierend auf den genannten Diisocyanaten geeignete Bausteine der Komponente A.

Die als Komponente B) einsetzbaren Polyisocyanat-Prepolymere können durch Umsetzung von einem oder mehreren Diisocyanaten mit einem oder mehreren hydroxyfunktionellen, insbesondere polymeren, Polyolen gegebenenfalls unter Zusatz von Katalysatoren sowie Hilfs- und Zusatzstoffen erhalten werden. Des Weiteren können zusätzlich Komponenten zur Kettenverlängerung, wie beispielsweise mit primären und/oder sekundären Aminogruppen (NH₂- und/oder NH-funktionelle Komponenten), für die Bildung des Polyisocyanat-Prepolymers eingesetzt werden.

Hydroxyfunktionelle, polymere Polyole für die Umsetzung zum Polyisocyanat Prepolymer B) können erfindungsgemäß beispielsweise Polyesterpolyole, Polyacrylatpolyole, Polyurethanpolyole, Polycarbonatpolyole, Polyetherpolyole, Polyesterpolyacrylatpolyole, Polyurethanpolyacrylatpolyole, Polyurethanpolyesterpolyole, Polyurethanpolyetherpolyole, Polyurethanpolycarbonatpolyole und/oder Polyesterpolycarbonatpolyole sein. Diese können zur Herstellung des Polyisocyanat-Prepolymers einzeln oder in beliebigen Mischungen untereinander eingesetzt werden.

Zur Herstellung der Polyisocyanat-Prepolymere B) können Diisocyanate mit den Polyolen bei einem Verhältnis der Isocyanatgruppen zu Hydroxylgruppen (NCO/OH-Verhältnis) von 2:1 bis 20:1, beispielsweise von 8:1, umgesetzt werden. Dabei können Urethan- und/oder Allophanatstrukturen gebildet werden. Ein Anteil an nicht umgesetzten Polyisocyanaten kann anschließend abgetrennt werden. Hierfür kann beispielsweise eine Dünnschichtdestillation verwendet werden, wobei restmonomerenarme Produkte mit Restmonomergehalten von beispielsweise ≤ 1 Gewichtsprozent, bevorzugt ≤ 0,5 Gewichtsprozent, besonders bevorzugt ≤ 0,1 Gewichtsprozent, erhalten werden. Die Reaktionstemperatur kann dabei von 20 °C bis 120 °C, bevorzugt von 60 °C bis 100 °C, betragen. Gegebenenfalls können während der Herstellung Stabilisatoren wie Benzoylchlorid, Isophthaloylchlorid, Dibutylphosphat, 3-Chlorpropionsäure oder Methyltosylat zugesetzt werden.

Weiterhin können NH₂- und/oder NH-funktionelle Komponenten zusätzlich zur Kettenverlängerung bei der Herstellung der Polyisocyanat-Prepolymere B) eingesetzt werden.

Erfindungsgemäß geeignete Komponenten zur Kettenverlängerung sind organische Di- oder Polyamine. Beispielsweise können Ethylendiamin, 1,2- Diaminopropan, 1,3-Diaminopropan, 1,4-Diaminobutan, 1,6-Diaminohexan, Isophorondiamin, Isomerengemisch von 2,2,4- und 2,4,4-Trimethylhexamethylendiamin, 2-Methylpentamethylendiamin, Diethylentriamin, Diaminodicyclohexylmethan oder Dimethylethylendiamin oder Mischungen davon eingesetzt werden. Darüber hinaus können auch Verbindungen, die neben einer primären Aminogruppe auch sekundäre Aminogruppen oder neben einer Aminogruppe (primär oder sekundär) auch OH-Gruppen aufweisen, zur Herstellung der Polyisocyanat-Prepolymere B) eingesetzt werden. Beispiele hierfür sind primäre/sekundäre Amine, wie Diethanolamin, 3-Amino-1-methylaminopropan, 3-Amino-1-ethylaminopropan, 3-Amino-1-cyclohexylaminopropan, 3 -Amino-1 -methylaminobutan, Alkanolamine wie N-Aminoethylethanolamin, Ethanolamin, 3-Aminopropanol, Neopentanolamin. Zur Kettenterminierung werden üblicherweise Amine mit einer gegenüber Isocyanaten reaktiven Gruppe wie Methylamin, Ethylamin, Propylamin, Butylamin, Octylamin, Laurylamin, Stearylamin, Isononyloxypropylamin, Dimethylamin, Diethylamin, Dipropylamin, Dibutylamin, N-Methylaminopropylamin, Diethyl(methyl)aminopropylamin, Morpholin, Piperidin, beziehungsweise geeignete substituierte Derivate davon, Amidamine aus diprimären Aminen und Monocarbonsäuren, Monoketim von diprimären Ammen, primär/tertiäre Amine, wie N,N-Dimethylaminopropylamin, verwendet.

Die als Komponente B) erfindungsgemäß eingesetzten Polyisocyanat-Prepolymere oder deren Mischungen können bevorzugt eine mittlere NCO-Funktionalität von ≥ 1,8 bis ≤ 5, besonders bevorzugt ≥ 2 bis ≤ 3,5 und ganz besonders bevorzugt ≥ 2 bis ≤ 2,5 aufweisen.

Im Rahmen der vorliegenden Erfindung kann Komponente C) grundsätzlich eine Verbindung mit mindestens zwei isocyanatreaktiven Hydroxygruppen sein. Beispielsweise kann Komponente C) ein Polyol mit mindestens zwei isocyanatreaktiven Hydroxygruppen sein.

Es gelten natürlich die zuvor genannten Bedingungen hinsichtlich des Vorliegens und der Gestalt von Polytetramethylenglykolether-Einheiten der allgemeinen Formel (I) in dem Polyurethanpolymer.

Das eingesetzte Äquivalent-Verhältnis der Isocyanatgruppen aus A) zu den Isocyanatgruppen aus B) liegt vorteilhafterweise zwischen ≥ 1:10 bis ≤ 10:1, besonders bevorzugt ≥ 1:5 zu ≤ 5:1 und ganz besonders bevorzugt ≥ 1:3 zu ≤ 3:1.

Im Rahmen der vorliegenden Erfindung werden die Begriffe "ein" und "eine" im Zusammenhang mit den Komponenten A), B) und C) nicht als Zahlwörter, sondern als unbestimmter Artikel verwendet.

In einer Ausführungsform des erfindungsgemäßen elektromechanischen Wandlers ist in der allgemeinen Formel (I) weiterhin n ≤ 29. Ein Wert für n ≥ 25 bis ≤ 29 lässt sich realisieren, indem ein Polytetramethylenglykolether-Polyol mit einer durchschnittlichen Molekülmasse von 2000 g/mol in der Herstellung des Polyurethan-Polymers eingesetzt wird. Solche Polyole sind zum Beispiel kommerziell unter den Handelsnamen PolyTHF® 2000 oder Terathane® 2000 erhältlich. Der Wert für n kann auch ≤ 28 oder ≤ 27 sein.

In einer weiteren Ausführungsform des erfindungsgemäßen elektromechanischen Wandlers ist das Polyurethanpolymer erhältlich aus der Reaktion eines trifunktionellen Polyisocyanurats A) mit einem Polytetramethylenglykolether-Polyol C). Vorzugsweise handelt es sich bei dem trifunktionellen Polyisocyanurat um ein Trimer eines aliphatischen Diisocyanats. Besonders bevorzugt ist es ein Isocyanurat aus drei Molekülen Hexamethylendiisocyanat.

In einer weiteren Ausführungsform des erfindungsgemäßen elektromechanischen Wandlers ist das Polyurethanpolymer erhältlich aus der Reaktion eines Polyurethan-Prepolymers B) mit einem Polyalkylenoxidpolyether-Polyol C) und das Polyurethan-Prepolymer B) ist erhältlich aus der Reaktion eines difunktionellen Polyisocyanats mit einem Polytetramethylenglykolether-Polyol. Besonders geeignete Polyisocyanate zum Aufbau des Prepolymers sind Hexamethylendiisocyanat und 4,4'-Diphenyhnethandüsocyanat. Das Prepolymer wird anschließend mit einem Polyalkylenoxidpolyether-Polyol kettenverlängert. Geeignete Polyole hierzu sind insbesondere Polypropylenoxidpolyether-Polyole oder Polypropylenoxid-polyethylenoxidether-Polyole. Die Polyole zur Kettenverlängerung sind vorzugsweise difunktionell oder trifunktionell. Die zahlenmittlere Molekülmasse kann beispielsweise ≥ 2000 g/mol bis ≤ 6000 g/mol betragen.

In einer weiteren Ausführungsform des erfindungsgemäßen elektromechanischen Wandlers ist das Polyurethanpolymer erhältlich aus der Reaktion eines isocyanatfunktionellen Polyurethan-Prepolymers B) mit einem Polytetramethylenglykolether-Polyol C). Hierbei dient das polymere THF zur Kettenverlängerung des Prepolymers.

Bevorzugt an dieser Ausführungsform ist, wenn in der Reaktion zu dem Polyurethanpolymer weiterhin ein trifunktionelles Polyisocyanurat A) vorhanden ist. Vorzugsweise handelt es sich bei dem trifunktionellen Polyisocyanurat um ein Trimer eines aliphatischen Diisocyanats. Besonders bevorzugt ist es ein Isocyanurat aus drei Molekülen Hexamethylendiisocyanat.

In einer weiteren Ausführungsform des erfindungsgemäßen elektromechanischen Wandlers ist das Polyurethanpolymer erhältlich aus der Reaktion eines Polyurethan-Prepolymers B) mit einem Polytetramethylenglykolether-Polyol C) und das Polyurethan-Prepolymer B) ist erhältlich aus der Reaktion eines difunktionellen Polyisocyanats mit einem Polytetramethylenglykolether-Polyol. Hierbei dient das polymere THF sowohl zum Aufbau des Prepolymers als auch zu dessen Kettenverlängerung.

In einer weiteren Ausführungsform des erfindungsgemäßen elektromechanischen Wandlers beträgt in dem Polyurethanpolymer der Anteil von Polytetramethylenglykolether-Einheiten ≥ 20 Gewichts-% bis ≤ 90 Gewichts-%. Vorzugsweise liegt dieser Anteil zwischen ≥ 25 Gewichts-% und ≤ 80 Gewichts-% und mehr bevorzugt zwischen ≥ 30 Gewichts-% und ≤ 50 Gewichts-%.

In einer weiteren Ausführungsform des erfindungsgemäßen elektromechanischen Wandlers weist das Polyurethanpolymer ein Elastizitätsmodul bei einer Dehnung von 50% von ≥ 0,1 MPa bis ≤ 10 MPa auf. Der Modul wird hierbei nach DIN EN 150 672 1-1 bestimmt und kann auch ≥ 0,2 MPa bis ≤ 5 MPa betragen. Weiterhin kann das Polyurethanpolymer eine maximale Spannung von ≥ 0,2 MPa, insbesondere von ≥ 0,4 MPa bis ≤ 50 MPa und eine maximale Dehnung von ≥ 250 %, insbesondere von ≥ 350 %, aufweisen. Darüber hinaus kann das erfindungsgemäße Polymerelement im Gebrauchsdehnungsbereich von ≥ 50 % bis ≤ 200 % eine Spannung von ≥ 0,1 MPa bis ≤ 1 MPa, beispielsweise von ≥ 0,15 MPa bis ≤ 0,8 MPa, insbesondere von ≥ 0,2 MPa bis ≤ 0,3 MPa, aufweisen (Bestimmung nach DIN 53504).

Ein weiterer Gegenstand der vorliegenden Erfindung ist ein Verfahren zur Herstellung eines elektromechanischen Wandlers, umfassend die Schritte:
- Bereitstellen einer ersten Elektrode und einer zweiten Elektrode;
- Bereitstellen eines dielektrischen Elastomers, wobei das dielektrische Elastomer ein Polyurethanpolymer umfasst und das Polyurethanpolymer erhältlich ist aus der Reaktion von
   A) einem Polyisocyanat und/oder B) einem Polyisocyanat-Prepolymer
      mit C) einer Verbindung mit mindestens zwei isocyanatreaktiven Gruppen;
      wobei das Polyisocyanat-Prepolymer B) und/oder die Verbindung mit mindestens zwei isocyanatreaktiven Gruppen C) Polytetramethylenglykolether-Einheiten der allgemeinen Formel (I) umfassen:

      -[O-CH₂-CH₂-CH₂-CH₂-]ₙ (I)

      mit n ≥ 25; und
      mit einem Minimalwert nₘᵢₙ für den Wert n und einem Maximalwert nₘₐₓ für den Wert n in der allgemeinen Formel (I);
      wobei die Differenz zwischen nₘₐₓ und nₘᵢₙ ≥ 0 bis ≤ 4 beträgt;
      wobei für den Fall, dass das Polyisocyanat-Prepolymer B) und die Verbindung mit mindestens zwei isocyanatreaktiven Gruppen C) Polytetramethylenglykolether-Einheiten der allgemeinen Formel (I) umfassen, die Werte n, nₘₐₓ und nₘᵢₙ bezüglich des Polyisocyanat-Prepolymers B) einerseits und der Verbindung mit mindestens zwei isocyanatreaktiven Gruppen C) andererseits gleich oder verschieden sein können; und
      wobei in dem Polyisocyanat-Prepolymer B) und in der Verbindung mit mindestens zwei isocyanatreaktiven Gruppen C) jeweils für sich gesehen keine weiteren Polytetramethylenglykolether-Einheiten neben denjenigen der allgemeinen Formel (I) vorhanden sind;
- Anordnen des dielektrischen Elastomers zwischen die erste Elektrode und die zweite Elektrode.

Details zu dem Polyurethanpolymer einschließlich der Ausführungsformen wurden bereits im Zusammenhang mit der erfindungsgemäßen Vorrichtung beschrieben. Zur Vermeidung von unnötigen Wiederholungen wird bezüglich des Verfahrens auf dieses Bezug genommen.

In einer Ausführungsform des erfindungsgemäßen Verfahrens erfolgt das Bereitstellen des dielektrischen Elastomers, indem eine zu dem Polyurethan-Polymer führende Reaktionsmischung auf die erste und/oder zweite Elektrode aufgetragen wird. Der Vorteil dieser Vorgehensweise ist insbesondere, dass das aushärtende Elastomer eine gute Haftung zu den Elektroden aufbauen kann.

Das Auftragen der Reaktionsmischung kann beispielsweise durch Rakeln, Streichen, Gießen, Schleudern, Sprühen oder Extrusion erfolgen.

Vorzugsweise wird die Reaktionsmischung getrocknet und/oder getempert. Das Trocknen kann dabei in einem Temperaturbereich von 0 °C bis 200 °C, beispielsweise für 0,1 min bis 48 h, insbesondere für 6 h bis 18 h erfolgen. Das Tempern kann beispielsweise in einem Temperaturbereich von 80 °C bis 250 °C, beispielsweise für 0,1 min bis 24 h, erfolgen.

Die vorliegende Erfindung betrifft weiterhin die Verwendung eines dielektrischen Elastomers als Aktor, Sensor und/oder Generator in einem elektromechanischen Wandler, wobei das dielektrische Elastomer ein Polyurethanpolymer umfasst und das Polyurethanpolymer erhältlich ist aus der Reaktion von
A) einem Polyisocyanat und/oder B) einem Polyisocyanat-Prepolymer

   mit C) einer Verbindung mit mindestens zwei isocyanatreaktiven Gruppen;
   wobei das Polyisocyanat-Prepolymer B) und/oder die Verbindung mit mindestens zwei isocyanatreaktiven Gruppen C) Polytetramethylenglykolether-Einheiten der allgemeinen Formel (I) umfassen:

   -[O-CH₂-CH₂-CH₂-CH₂-]ₙ (I)

   mit n ≥ 25; und
   mit einem Minimalwert nₘᵢₙ für den Wert n und einem Maximalwert nₘₐₓ für den Wert n in der allgemeinen Formel (I);
   wobei die Differenz zwischen nₘₐₓ und nₘᵢₙ ≥ 0 bis ≤ 4 beträgt;
   wobei für den Fall, dass das Polyisocyanat-Prepolymer B) und die Verbindung mit mindestens zwei isocyanatreaktiven Gruppen C) Polytetramethylenglykolether-Einheiten der allgemeinen Formel (I) umfassen, die Werte n, nₘₐₓ und nₘᵢₙ bezüglich des Polyisocyanat-Prepolymers B) einerseits und der Verbindung mit mindestens zwei isocyanatreaktiven Gruppen C) andererseits gleich oder verschieden sein können; und
   wobei in dem Polyisocyanat-Prepolymer B) und in der Verbindung mit mindestens zwei isocyanatreaktiven Gruppen C) jeweils für sich gesehen keine weiteren Polytetramethylenglykolether-Einheiten neben denjenigen der allgemeinen Formel (I) vorhanden sind.

Details zu dem Polyurethanpolymer einschließlich der Ausführungsformen wurden bereits im Zusammenhang mit der erfindungsgemäßen Vorrichtung beschrieben. Zur Vermeidung von unnötigen Wiederholungen wird bezüglich dessen Verwendung hierauf Bezug genommen.

Verwendungen finden sich in einer Vielzahl von verschiedensten Anwendungen im elektromechanischen und elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie. Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden sowie Systeme zur Umwandlung von Wasserwellenenergie, insbesondere Meereswellenenergie, in elektrische Energie.

Ein weiterer Gegenstand der Erfindung ist eine Elektrische und/oder elektronische Vorrichtung, umfassend einen erfindungsgemäßen elektromechanischen Wandler.

Durch die nachfolgend aufgeführten Beispiele soll die Erfindung weiter erläutert werden, ohne auf diese beschränkt zu sein.

### Beispiele:

Sofern nicht abweichend gekennzeichnet, beziehen sich alle Prozentangaben auf das Gewicht und alle analytischen Messungen beziehen sich auf Temperaturen von 23 °C. NCO-Gehalte wurden, wenn nicht ausdrücklich anders erwähnt, volumetrisch gemäß DIN-EN ISO 11909 bestimmt.

Die angegebenen Viskositäten wurden mittels Rotationsviskosimetrie nach DIN 53019 bei 23 °C mit einem Rotationsviskosimeter der Firma Anton Paar Germany GmbH bestimmt.

Die Zugversuche wurden mittels einer Zugmaschine der Firma Zwick, Modell Nummer 1455, ausgestattet mit einer Kraftmessdose des Gesamtmessbereiches 1 kN nach DIN 53 504 mit einer Zuggeschwindigkeit von 50 mm/min ausgeführt. Als Probekörper wurden S2-Zugstäbe eingesetzt. Jede Messung wurde an drei gleichartig präparierten Probekörpern ausgeführt und der Mittelwert der erhaltenen Daten zur Bewertung verwendet. Es wurde die Spannung in [MPa] bei 50% Dehnung bestimmt.

Die Bestimmung des elektrischen Widerstandes geschah mittels eines Laboraufbaus der Firma Keithley Instruments, Modell Nr.: 6517 A und 8009, gemäß ASTM D 257 (einer Methode zur Bestimmung des Isolationswiderstandes von Werkstoffen).

Die Bestimmung der Durchbruchsfeldstärke gemäß ASTM D 149-97a wurde mit einer Hochspannungsquelle Modell hypotMAX der Firma Associated Research Inc. und einem eigenkonstruierten Probenhalter durchgeführt. Der Probenhalter kontaktiert die homogen dicken Polymerproben mit nur geringer mechanischer Vorbelastung und verhindert, dass der Bediener in Kontakt mit der Spannung kommt. Die nicht vorgespannte Polymerfolie wurde in diesem Aufbau mit steigender Spannung statisch belastet, bis ein elektrischer Durchbruch durch die Folie erfolgte. Das Messergebnis ist die beim Durchbruch erreichte Spannung, bezogen auf die Dicke der Polymerfolie in [V/µm]. Es wurden je Folie 5 Messungen ausgeführt und der Mittelwert angegeben.

### Verwendete Substanzen und Abkürzungen:

- Desmodur® N 3300:: trifunktionelles Isocyanurat auf Basis von Hexamethylendiisocyanat (HDI-Trimer), NCO-Gehalt 21,8 ± 0,3 % (nach DIN EN ISO 11 909), Viskosität bei 23 °C 3000 ± 750 mPa·s, Bayer MaterialScience AG
- Desmodur® 44M: 4,4'-Methylendiphenyldiisocyanat, Bayer MaterialScience AG
- Terathane® 2000: Polytetramethylenetherglykol mit Mₙ = 2000 g/mol, INVISTA Resins & Fibers
- Terathane® 650: Polytetramethylenetherglykol mit Mₙ = 650 g/mol, INVISTA Resins & Fibers
- PoIyTHF® 2000: difunktioneller Polytetraethylenglykol-Polyether mit Mₙ = 2000 g/mol, BASF SE
- Arcol® PPG 2000: Polypropylenglykol mit Mₙ = 2000 g/mol, Bayer MaterialScience AG
- Acclaim® 6320: trifunktioneller Polypropylenglykol-polyethylenglykol-Polyether mit Mₙ = 6000 g/mol und einem Anteil an Ethylenoxid-Einheiten von 20 Gewichts-%, Bayer MaterialScience AG
- DBTDL: Dibutyl-Zinn-Dilaurat, E. Merck KGaA

### Beispiel 1: Herstellung eines di-isocyanatfunktionellen Polyisocyanat-Prepolymers

1300 g Hexamethylen-1,6-diisocyanat (HDI), 1,3 g Benzoylchlorid und 1,3 g para-Toluolsulfonsäuremethylester wurden in einem 4 Liter Vierhalskolben unter Rühren vorgelegt. Innerhalb von 3 Stunden fügte man bei 80 °C 1456 g Arcol® PPG 2000 hinzu und rührte 1 Stunde bei gleicher Temperatur nach. Anschließend wurde durch Dünnschichtdestillation bei 130 °C und 0,1 Torr das überschüssige HDI abdestilliert. Im Vorlagekolben befand sich 1 g Chlorpropionsäure. Das erhaltene NCO-Prepolymer hatte einen NCO-Gehalt von 3,23% und eine Viskosität von 1650 mPas (25 °C).

### Beispiel 2: Herstellung eines di-isocyanatfunktionellen Polyisocyanat-Prepolymers

1300 g Hexamethylen-1,6-diisocyanat (HDI) und 0,27 g Dibutylphosphat wurden in einem 4 Liter Vierhalskolben unter Rühren vorgelegt. Innerhalb von 3 Stunden fügte man bei 80 °C 1456 g eines difunktionellen Polypropylenglykol-Polyethers mit einem zahlenmittleren Molekulargewicht von 2000 g/mol hinzu und rührte 1 Stunde bei gleicher Temperature nach Anschließend wurde durch Dünnschichtdestillation bei 130 °C und 0,1 Torr das überschüssige HDI abdestilliert. Das erhaltene NCO-Prepolymer hatte einen NCO-Gehalt von 3,27% und eine Viskosität von 1680 mPas (25 °C).

### Beispiel 3:

### Herstellung eines di-isocyanatfunktionellen Polyisocyanat-Prepolymers

1300 g Hexamethylen-1,6-diisocyanat (HDI) und 1,3 g Benzoylchlorid wurden in einem 4 Liter Vierhalskolben unter Rühren vorgelegt. Innerhalb von 3 Stunden fügte man bei 80 °C 1456 g eines difunktionellen Polypropylenglykol-Polyethers mit einem zahlenmittleren Molekulargewicht von 2000 g/mol hinzu und rührte 1 Stunde bei gleicher Temperatur nach. Anschließend wurde durch Dünnschichtdestillation bei 130 °C und 0,1 Torr das überschüssige HDI abdestilliert. Das erhaltene NCO-Prepolymer hatte einen NCO-Gehalt von 3,27% und eine Viskosität von 1500 mPas (25 °C).

### Beispiel 4:

### Herstellung eines tetra-isocyanatfunktionellen Polyisocyanat-Prepolymers

1000 g Hexamethylen-1,6-diisocyanat (HDI) und 0,15 g Zirkonoktoat wurden in einem 4 Liter Vierhalskolben unter Rühren vorgelegt. Dann fügte man bei 80 °C 1000 g PolyTHF® 2000 hinzu und rührte 5 Stunden bei 115 °C nach, wobei noch 3 Mal im Stundenabstand 0,15 g Zirkonoktoat zugesetzt wurden. Nach Ablauf der Zeit wurden 0,5 g Dibutylphosphat zugesetzt. Anschließend wurde durch Dünnschichtdestillation bei 130 °C und 0,1 Torr das überschüssige HDI abdestilliert. Das erhaltene NCO-Prepolymer hatte einen NCO-Gehalt von 6,18% und eine Viskosität von 25700 mPas (25 °C).

### Beispiel 5:

### Herstellung eines tri-isocyanatfunktionellen Polyisocyanat-Prepolymers

Zur Herstellung des Präpolymeren wurden 7,15 kg Desmodur 44M® in einem Rührwerksbehälter bei einer Temperatur von 50 °C vorgelegt und 45,85 kg eines trifunktionellen Polypropylenglykol-polyethylenglykol-Polyethers mit einem zahlenmittleren Molekulargewicht von 6000 g/mol und einem Anteil an Ethylenoxid-Einheiten von 0 Gewichts-% (auf Raumtemperatur temperiert) innerhalb von 15 min zugegeben. Wahlweise kann auch der Polyether bei 50 °C vorgelegt und danach das ebenfalls auf 50 °C erwärmte Isocyanat zugegeben werden. Danach wurde zur Reaktion auf 100 °C aufgeheizt und weitere 7 Stunden bei dieser Temperatur gehalten. Nach dem Abkühlen erhielt man ein Produkt mit einem NCO-Gehalt von 2,70 ± 0,1% und einer Viskosität von 4200 + 600 mPas (70 °C).

### Vergleichsbeispiel V1:

### Herstellung eines nicht erfindungsgemäß zu verwendenden Polymers

Die eingesetzten Rohstoffe wurden nicht separat entgast. 8 g Prepolymer aus Beispiel 1 wurde mit 2 g Desmodur® N3300 im Speedmixer für die Dauer von 1 min bei 3000 U/min vermischt und die Mischung mit 16,3 g Arcol® PPG 2000 und mit 0,016 g DBTDL in einem Polypropylen-Becher im Speedmixer ebenfalls bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Vergleichsbeispiel V2:

### Herstellung eines nicht erfindungsgemäß zu verwendenden Polymers

Die eingesetzten Rohstoffe wurden nicht separat entgast. 8 g Prepolymer aus Beispiel 3 wurde mit 2 g Desmodur® N3300 im Speedmixer für die Dauer von 1 min bei 3000 U/min vermischt und die Mischung mit 16,1 g Arcol® PPG 2000 mit 0,016g DBTDL in einem Polypropylen-Becher im Speedmixer ebenfalls bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Vergleichsbeispiel V3:

### Herstellung eines nicht erfindungsgemäß zu verwendenden Polymers

Die eingesetzten Rohstoffe wurden nicht separat entgast. 7,82 g Desmodur® N3300 wurde mit 39,88 g Arcol® PPG 2000 und mit 0,12 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Vergleichsbeispiel V4:

### Herstellung eines nicht erfindungsgemäß zu verwendenden Polymers

Alle flüssigen Rohstoffe wurden in einem dreistufigen Verfahren sorgfältig unter Argon entgast. 10 g Terathane® 650 wurden in einem 60 ml Einweg-Mischbehälter eingewogen. Anschließend wurden 0,005 g Dibutylzinndilaurat und 6,06 g Desmodur® N3300 dazu gewogen und 1 min bei 3000 Umdrehungen pro Minute im Speedmixer vermischt. Das Reaktionsprodukt wurde auf eine Glasplatte gegossen und mit einem Rakel der Nassschichtdicke 1 mm zu einem homogenen Film ausgezogen. Der Film wurde anschließend 16 h bei 80 °C getempert.

### Erfindungsgemäßes Beispiel E1 :

### Herstellung eines erfindungsgemäß zu verwendenden Polymers

Die eingesetzten Rohstoffe wurden nicht separat entgast. 8,65 g eines Prepolymeren aus Beispiel 4 und 25,0 g Acclaim® 6320 wurden mit einer Menge von 0,075 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Erfindungsgemäßes Beispiel E2:

### Herstellung eines erfindungsgemäß zu verwendenden Polymers

Die eingesetzten Rohstoffe wurden nicht separat entgast. 5,0 g Desmodur® N 3300 und 20,0 g des Prepolymers aus Beispiel 2 wurden in einem Polypropylen-Becher eingewogen und im Speedmixer bei 3000 Umdrehungen pro Minute für 1 Minute miteinander vermischt. Diese Mischung wurde dann mit 38,54 g Terathane® 2000 mit einer Menge von 0,01 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Erfindungsgemäßes Beispiel E3:

### Herstellung eines erfindungsgemäß zu verwendenden Polymers

Die eingesetzten Rohstoffe wurden nicht separat entgast. 19,94 g des Prepolymeren aus Beispiel 4 und 30,0 g Terathane® 2000 wurden mit einer Menge von 0,03 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Erfindungsgemäßes Beispiel E4:

### Herstellung eines erfindungsgemäß zu verwendenden Polymers

Die eingesetzten Rohstoffe wurden nicht separat entgast. 14,27 g des Prepolymeren aus Beispiel 4 wurde mit 30,0 g Terathane® 2900 und einer Menge von 0,03 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Erfindungsgemäßes Beispiel E5:

### Herstellung eines erfindungsgemäß zu verwendenden Polymers

Die eingesetzten Rohstoffe wurden nicht separat entgast. 1,96 g des Desmodur® N3300 wurde mit 10,0 g Terathane® 2000 und einer Menge von 0,005 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Erfindungsgemäßes Beispiel E6:

### Herstellung eines erfindungsgemäß zu verwendenden Polymers

Die eingesetzten Rohstoffe wurden nicht separat entgast. 6,7 g Desmodur® N3300 wurde mit 50,0 g Terathane® 2900 und einer Menge von 0,05 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Erfindungsgemäßes Beispiel E7:

### Herstellung eines erfindungsgemäß zu verwendenden Polymers

Die eingesetzten Rohstoffe wurden nicht separat entgast. 55,2 g des Prepolymeren aus Beispiel 5 wurde mit 33,3 g Terathane® 2000 und einer Menge von 0,00083 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

An den Proben wurden der elektrische Widerstand und die Durchbruchsfeldstärke bestimmt. Die Ergebnisse für die nicht erfindungsgemäßen Beispiele und die Beispiele für erfindungsgemäße Polymerelemente sind in der nachfolgenden Tabelle 1 dargestellt. Zahlenwerte der Volumenwiderstände sind in Exponentialschreibweise angegeben. So bedeutet der Zahlenwert zum Beispiel V1 einen Volumen-Widerstand von 2,915 · 10¹⁰ Ohm cm. Weiterhin zeigt die Tabelle die Elastizitätsmodule der Polymere bei 50% Dehnung gemäß DIN EN 150 672 1-1.

**Tabelle 1: Eigenschaften der in den Beispielen V1 bis V3 und E1 bis E7 hergestellten Filme**

| Beispiel | Volumen-Widerstand [Ohm cm] | Durchbruchsfeldstärke [V/µm] | E-Modul [MPa] |
|---|---|---|---|
| | | | |
| V1 | 2,915E+10 | 25,9 | 0,33 |
| V2 | 1,514E+10 | 17,5 | 0,11 |
| V3 | 2,254E+10 | 18,0 | 0,24 |
| V4 | 2,33E+11 | 11 | * |
| | | | |
| E1 | 7,46E+10 | 32,0 | 0,60 |
| E2 | 2,15E+11 | 45,8 | 0,95 |
| E3 | 5,256E+12 | 57,0 | 1,84 |
| E4 | 3,216E+12 | 55,4 | 1,66 |
| E5 | 1,002E+11 | 26,1 | 1,89 |
| E6 | 3,318E+12 | 64,0 | 1,77 |
| E7 | 1,36E+12 | 101,0 | 1,05 |

*: Die Probe reißt bereits bei 44% Dehnung.

Es zeigte sich bei den Versuchen, dass die erfindungsgemäßen Polymerelemente als Filme deutliche Vorteile gegenüber dem Stand der Technik bieten. Hervorzuheben ist besonders das Vergleichsbeispiel V4, bei dem mit einer kurzen Kettenlänge des polymeren THF zwar ein höherer Volumen-Widerstand als bei den Beispielen V1, V2 und V3, aber nur eine vergleichsweise geringe Durchbruchsfeldstärke erreicht wurde.

Besonders vorteilhaft bei Einsatz der erfindungsgemäßen Filme ist die Kombination aus sehr hohem elektrischen Widerstand und hoher Durchbruchsfeldstärke. Mit diesen erfindungsgemäßen Polymerelementen können vorteilhaft besonders günstige Wirkungsgrade der damit hergestellten elektromechanischen Wandler erzielt werden.

## Patentansprüche

1. Elektromechanischer Wandler, umfassend ein durch eine erste Elektrode und eine zweite Elektrode kontaktiertes dielektrisches Elastomer, wobei das dielektrische Elastomer ein Polyurethanpolymer umfasst,
**dadurch gekennzeichnet, dass**
das Polyurethanpolymer erhältlich ist aus der Reaktion von
A) einem Polyisocyanat und/oder B) einem Polyisocyanat-Prepolymer
mit C) einer Verbindung mit mindestens zwei isocyanatreaktiven Gruppen;
wobei das Polyisocyanat-Prepolymer B) und/oder die Verbindung mit mindestens zwei isocyanatreaktiven Gruppen C) Polytetramethylenglykolether-Einheiten der allgemeinen Formel (I) umfassen:
-[O-CH₂-CH₂-CH₂-CH₂-]ₙ (I)
mit n ≥ 25; und
mit einem Minimalwert nₘᵢₙ für den Wert n und einem Maximalwert nₘₐₓ für den Wert n in der allgemeinen Formel (I);
wobei die Differenz zwischen nₘₐₓ und nₘᵢₙ ≥ 0 bis ≤ 4 beträgt;
wobei für den Fall, dass das Polyisocyanat-Prepolymer B) und die Verbindung mit mindestens zwei isocyanatreaktiven Gruppen C) Polytetramethylenglykolether-Einheiten der allgemeinen Formel (I) umfassen, die Werte n, nₘₐₓ und nₘᵢₙ bezüglich des Polyisocyanat-Prepolymers B) einerseits und der Verbindung mit mindestens zwei isocyanatreaktiven Gruppen C) andererseits gleich oder verschieden sein können; und
wobei in dem Polyisocyanat-Prepolymer B) und in der Verbindung mit mindestens zwei isocyanatreaktiven Gruppen C) jeweils für sich gesehen keine weiteren Polytetramethylenglykolether-Einheiten neben denjenigen der allgemeinen Formel (I) vorhanden sind.

2. Elektromechanischer Wandler gemäß Anspruch 1, wobei in der allgemeinen Formel (I) weiterhin n ≤ 29 ist.

3. Elektromechanischer Wandler gemäß Anspruch 1, wobei das Polyurethanpolymer erhältlich ist aus der Reaktion eines trifunktionellen Polyisocyanurats A) mit einem Polytetramethylenglykolether-Polyol C).

4. Elektromechanischer Wandler gemäß Anspruch 1, wobei das Polyurethanpolymer erhältlich ist aus der Reaktion eines Polyurethan-Prepolymers B) mit einem Polyalkylenoxidpolyether-Polyol C) und wobei das Polyurethan-Prepolymer B) erhältlich ist aus der Reaktion eines difunktionellen Polyisocyanats mit einem Polytetramethylenglykolether-Polyol.

5. Elektromechanischer Wandler gemäß Anspruch 1, wobei das Polyurethanpolymer erhältlich ist aus der Reaktion eines isocyanatfunktionellen Polyurethan-Prepolymers B) mit einem Polytetramethylenglykolether-Polyol C).

6. Elektromechanischer Wandler gemäß Anspruch 5, wobei in der Reaktion zu dem Polyurethanpolymer weiterhin ein trifunktionelles Polyisocyanurat A) vorhanden ist.

7. Elektromechanischer Wandler gemäß Anspruch 1, wobei das Polyurethanpolymer erhältlich ist aus der Reaktion eines Polyurethan-Prepolymers B) mit einem Polytetramethylenglykolether-Polyol C) und wobei das Polyurethan-Prepolymer erhältlich ist aus der Reaktion eines difunktionellen Polyisocyanats mit einem Polytetramethylenglykolether-Polyol.

8. Elektromechanischer Wandler gemäß Anspruch 1, wobei in dem Polyurethanpolymer der Anteil von Polytetramethylenglykolether-Einheiten ≥20 Gewichts% bis ≤90 Gewichts% beträgt.

9. Elektromechanischer Wandler gemäß Anspruch 1, wobei das Polyurethanpolymer ein Elastizitätsmodul bei einer Dehnung von 50% von ≥ 0,1 MPa bis ≤ 10 MPa aufweist.

10. Verfahren zur Herstellung eines elektromechanischen Wandlers, umfassend die Schritte:
- Bereitstellen einer ersten Elektrode und einer zweiten Elektrode;
- Bereitstellen eines dielektrischen Elastomers, wobei das dielektrische Elastomer ein Polyurethanpolymer umfasst und das Polyurethanpolymer erhältlich ist aus der Reaktion von
A) einem Polyisocyanat und/oder B) einem Polyisocyanat-Prepolymer
mit C) einer Verbindung mit mindestens zwei isocyanatreaktiven Gruppen;
wobei das Polyisocyanat-Prepolymer B) und/oder die Verbindung mit mindestens zwei isocyanatreaktiven Gruppen C) Polytetramethylenglykolether-Einheiten der allgemeinen Formel (1) umfassen:
-[O-CH₂-CH₂-CH₂-CH₂-]ₙ (I)
mit n ≥ 25; und
mit einem Minimalwert nₘᵢₙ für den Wert n und einem Maximalwert nₘₐₓ für den Wert n in der allgemeinen Formel (I);
wobei die Differenz zwischen nₘₐₓ und nₘᵢₙ ≥ 0 bis ≤ 4 beträgt;
wobei für den Fall, dass das Polyisocyanat-Prepolymer B) und die Verbindung mit mindestens zwei isocyanatreaktiven Gruppen C) Polytetramethylenglykolether-Einheiten der allgemeinen Formel (I) umfassen, die Werte n, nₘₐₓ und nₘᵢₙ bezüglich des Polyisocyanat-Prepolymers B) einerseits und der Verbindung mit mindestens zwei isocyanatreaktiven Gruppen C) andererseits gleich oder verschieden sein können; und
wobei in dem Polyisocyanat-Prepolymer B) und in der Verbindung mit mindestens zwei isocyanatreaktiven Gruppen C) jeweils für sich gesehen keine weiteren Polytetramethylenglykolether-Einheiten neben denjenigen der allgemeinen Formel (I) vorhanden sind;
- Anordnen des dielektrischen Elastomers zwischen die erste Elektrode und die zweite Elektrode.

11. Verfahren gemäß Anspruch 10, wobei das Bereitstellen des dielektrischen Elastomers erfolgt, indem eine zu dem Polyurethan-Polymer führende Reaktionsmischung auf die erste und/oder zweite Elektrode aufgetragen wird.

12. Verwendung eines dielektrischen Elastomers als Aktor, Sensor und/oder Generator in einem elektromechanischen Wandler, wobei das dielektrische Elastomer ein Polyurethanpolymer umfasst und das Polyurethanpolymer erhältlich ist aus der Reaktion von
A) einem Polyisocyanat und/oder B) einem Polyisocyanat-Prepolymer
mit C) einer Verbindung mit mindestens zwei isocyanatreaktiven Gruppen;
wobei das Polyisocyanat-Prepolymer B) und/oder die Verbindung mit mindestens zwei isocyanatreaktiven Gruppen C) Polytetramethylenglykolether-Einheiten der allgemeinen Formel (I) umfassen:
-[O-CH₂-CH₂-CH₂-CH₂-]ₙ (I)
mit n ≥ 25; und
mit einem Minimalwert nₘᵢₙ für den Wert n und einem Maximalwert nₘₐₓ für den Wert n in der allgemeinen Formel (I);
wobei die Differenz zwischen nₘₐₓ und nₘᵢₙ ≥ 0 bis ≤ 4 beträgt;
wobei für den Fall, dass das Polyisocyanat-Prepolymer B) und die Verbindung mit mindestens zwei isocyanatreaktiven Gruppen C) Polytetramethylenglykolether-Einheiten der allgemeinen Formel (I) umfassen, die Werte n, nₘₐₓ und nₘᵢₙ bezüglich des Polyisocyanat-Prepolymers B) einerseits und der Verbindung mit mindestens zwei isocyanatreaktiven Gruppen C) andererseits gleich oder verschieden sein können; und
wobei in dem Polyisocyanat-Prepolymer B) und in der Verbindung mit mindestens zwei isocyanatreaktiven Gruppen C) jeweils für sich gesehen keine weiteren Polytetramethylenglykolether-Einheiten neben denjenigen der allgemeinen Formel (I) vorhanden sind.

13. Elektrische und/oder elektronische Vorrichtung, umfassend einen elektromechanischen Wandler gemäß Anspruch 1.

## Claims

1. Electromechanical transducer comprising a dielectric elastomer with contacts by a first electrode and a second electrode, said dielectric elastomer comprising a polyurethane polymer,
**characterized in that**
said polyurethane polymer is obtainable from the reaction of
A) a polyisocyanate and/or B) a polyisocyanate prepolymer
with C) a compound having at least two isocyanate-reactive groups;
where the polyisocyanate prepolymer B) and/or the compound C) having at least two isocyanate-reactive groups comprise polytetramethylene glycol ether units of the general formula (I) :
-[O-CH₂-CH₂-CH₂-CH₂-]ₙ (I)
where n ≥ 25; and
with a minimum value nₘᵢₙ for the value n and a maximum value nₘₐₓ for the value n in the general formula (I);
where the difference between nₘₐₓ and nₘᵢₙ is ≥ 0 to s 4;
where, in the case that the polyisocyanate prepolymer B) and the compound C) having at least two isocyanate-reactive groups comprise polytetramethylene glycol ether units of the general formula (I) , the n, nₘₐₓ and nₘᵢₙ values, based on the polyisocyanate prepolymer B) on the one hand and the compound C) having at least two isocyanate-reactive groups on the other hand, may be the same or different; and
where, in the polyisocyanate prepolymer B) and in the compound C) having at least two isocyanate-reactive groups, each considered alone, no further polytetramethylene glycol ether units are present apart from those of the general formula (I).

2. Electromechanical transducer according to Claim 1, wherein n in the general formula (I) is additionally ≤ 29.

3. Electromechanical transducer according to Claim 1, wherein the polyurethane polymer is obtainable from the reaction of a trifunctional polyisocyanurate A) with a polytetramethylene glycol ether polyol C).

4. Electromechanical transducer according to Claim 1, wherein the polyurethane polymer is obtainable from the reaction of a polyurethane prepolymer B) with a polyalkylene oxide polyether polyol C), and wherein the polyurethane prepolymer B) is obtainable from the reaction of a difunctional polyisocyanate with a polytetramethylene glycol ether polyol.

5. Electromechanical transducer according to Claim 1, wherein the polyurethane polymer is obtainable from the reaction of an isocyanate-functional polyurethane prepolymer B) with a polytetramethylene glycol ether polyol C).

6. Electromechanical transducer according to Claim 5, wherein a trifunctional polyisocyanurate A) is additionally present in the reaction to give the polyurethane polymer.

7. Electromechanical transducer according to Claim 1, wherein the polyurethane polymer is obtainable from the reaction of a polyurethane prepolymer B) with a polytetramethylene glycol ether polyol C), and wherein the polyurethane prepolymer is obtainable from the reaction of a difunctional polyisocyanate with a polytetramethylene glycol ether polyol.

8. Electromechanical transducer according to Claim 1, wherein the proportion of polytetramethylene glycol ether units in the polyurethane polymer is ≥ 20% to s 90% by weight.

9. Electromechanical transducer according to Claim 1, wherein the polyurethane polymer has a modulus of elasticity at an elongation of 50% of ≥ 0.1 MPa to s 10 MPa.

10. Process for producing an electromechanical transducer, comprising the steps of:
- providing a first electrode and a second electrode;
- providing a dielectric elastomer, said dielectric elastomer comprising a polyurethane polymer, and said polyurethane polymer being obtainable from the reaction of
A) a polyisocyanate and/or B) a polyisocyanate prepolymer
with C) a compound having at least two isocyanate-reactive groups;
where the polyisocyanate prepolymer B) and/or the compound C) having at least two isocyanate-reactive groups comprise polytetramethylene glycol ether units of the general formula (I):
- [O-CH₂-CH₂-CH₂-CH₂-] ₙ (I)
where n ≥ 25; and
with a minimum value nₘᵢₙ for the value n and a maximum value nₘₐₓ for the value n in the general formula (I);
where the difference between nₘₐₓ and nₘᵢₙ is ≥ 0 to s 4;
where, in the case that the polyisocyanate prepolymer B) and the compound C) having at least two isocyanate-reactive groups comprise polytetramethylene glycol ether units of the general formula (I), the n, nₘₐₓ and nₘᵢₙ values, based on the polyisocyanate prepolymer B) on the one hand and the compound C) having at least two isocyanate-reactive groups on the other hand, may be the same or different; and
where, in the polyisocyanate prepolymer B) and in the compound C) having at least two isocyanate-reactive groups, each considered alone, no further polytetramethylene glycol ether units are present apart from those of the general formula (I);
- arranging the dielectric elastomer between the first electrode and the second electrode.

11. Process according to Claim 10, wherein the dielectric elastomer is provided by applying a reaction mixture which leads to the polyurethane polymer to the first and/or second electrode.

12. Use of a dielectric elastomer as an actuator, sensor and/or generator in an electromechanical transducer, wherein the dielectric elastomer comprises a polyurethane polymer and the polyurethane polymer is obtainable from the reaction of
A) a polyisocyanate and/or B) a polyisocyanate prepolymer
with C) a compound having at least two isocyanate-reactive groups;
where the polyisocyanate prepolymer B) and/or the compound C) having at least two isocyanate-reactive groups comprise polytetramethylene glycol ether units of the general formula (I) :
- [O-CH₂-CH₂-CH₂-CH₂-]ₙ (I)
where n ≥ 25; and
with a minimum value nₘᵢₙ for the value n and a maximum value nₘₐₓ for the value n in the general formula (I);
where the difference between nₘₐₓ and nₘᵢₙ is ≥ 0 to s 4;
where, in the case that the polyisocyanate prepolymer B) and the compound C) having at least two isocyanate-reactive groups comprise polytetramethylene glycol ether units of the general formula (I), the n, nₘₐₓ and nₘᵢₙ values, based on the polyisocyanate prepolymer B) on the one hand and the compound C) having at least two isocyanate-reactive groups on the other hand, may be the same or different; and
where, in the polyisocyanate prepolymer B) and in the compound C) having at least two isocyanate-reactive groups, each considered alone, no further polytetramethylene glycol ether units are present apart from those of the general formula (I).

13. Electric and/or electronic device comprising an electromechanical transducer according to Claim 1.

## Revendications

1. Convertisseur électromécanique, comprenant un élastomère diélectrique en contact avec une première électrode et une seconde électrode, l'élastomère diélectrique comprenant un polymère de polyuréthane, **caractérisé en ce que**
le polymère de polyuréthane peut être obtenu par la réaction de
A) un polyisocyanate et/ou B) un prépolymère de polyisocyanate
avec C) un composé contenant au moins deux groupes réactifs avec les isocyanates ;
le prépolymère de polyisocyanate B) et/ou le composé contenant au moins deux groupes réactifs avec les isocyanates C) comprenant des unités éther de polytétraméthylène glycol de formule générale (I) :
- [O-CH₂-CH₂-CH₂-CH₂]ₙ (I)
avec n ≥ 25 ; et
avec une valeur minimale nₘᵢₙ pour la valeur n et une valeur maximale nₘₐₓ pour la valeur n dans la formule générale (I) ;
la différence entre nₘₐₓ et nₘᵢₙ allant de ≥ 0 à s 4 ;
les valeurs n, nₘₐₓ et nₘᵢₙ pouvant être identiques ou différentes pour le prépolymère de polyisocyanate B) d'une part et pour le composé contenant au moins deux groupes réactifs avec les isocyanates C) d'autre part lorsque le prépolymère de polyisocyanate B) et le composé contenant au moins deux groupes réactifs avec les isocyanates C) comprennent des unités éther de polytétraméthylène glycol de formule générale (I) ; et aucune unité éther de polytétraméthylène glycol supplémentaire en plus de celles de formule générale (I) n'étant présente dans le prépolymère de polyisocyanate B) et dans le composé contenant au moins deux groupes réactifs avec les isocyanates C), chacun considéré séparément.

2. Convertisseur électromécanique selon la revendication 1, dans lequel n est également ≤ 29 dans la formule générale (I).

3. Convertisseur électromécanique selon la revendication 1, dans lequel le polymère de polyuréthane peut être obtenu par la réaction d'un polyisocyanurate trifonctionnel A) avec un polyol éther de polytétraméthylène glycol C).

4. Convertisseur électromécanique selon la revendication 1, dans lequel le polymère de polyuréthane peut être obtenu par la réaction d'un prépolymère de polyuréthane B) avec un polyol polyéther d'oxyde de polyalkylène C) et dans lequel le prépolymère de polyuréthane B) peut être obtenu par la réaction d'un polyisocyanate bifonctionnel avec un polyol éther de polytétraméthylène glycol.

5. Convertisseur électromécanique selon la revendication 1, dans lequel le polymère de polyuréthane peut être obtenu par la réaction d'un prépolymère de polyuréthane à fonction isocyanate B) avec un polyol éther de polytétraméthylène glycol C).

6. Convertisseur électromécanique selon la revendication 5, dans lequel un polyisocyanurate trifonctionnel A) est également présent dans la réaction pour former le polymère de polyuréthane.

7. Convertisseur électromécanique selon la revendication 1, dans lequel le polymère de polyuréthane peut être obtenu par la réaction d'un prépolymère de polyuréthane B) avec un polyol éther de polytétraméthylène glycol C) et dans lequel le prépolymère de polyuréthane peut être obtenu par la réaction d'un polyisocyanate bifonctionnel avec un polyol éther de polytétraméthylène glycol.

8. Convertisseur électromécanique selon la revendication 1, dans lequel la proportion d'unités éther de polytétraméthylène glycol dans le polymère de polyuréthane est de ≥ 20 % en poids à s 90 % en poids.

9. Convertisseur électromécanique selon la revendication 1, dans lequel le polymère de polyuréthane présente un module d'élasticité à un allongement de 50 % de ≥ 0,1 MPa à ≤ 10 MPa.

10. Procédé de fabrication d'un convertisseur électromécanique, comprenant les étapes suivantes :
- la préparation d'une première électrode et d'une seconde électrode ;
- la préparation d'un élastomère diélectrique, l'élastomère diélectrique comprenant un polymère de polyuréthane et le polymère de polyuréthane pouvant être obtenu par la réaction de
A) un polyisocyanate et/ou B) un prépolymère de polyisocyanate
avec C) un composé contenant au moins deux groupes réactifs avec les isocyanates ;
le prépolymère de polyisocyanate B) et/ou le composé contenant au moins deux groupes réactifs avec les isocyanates C) comprenant des unités éther de polytétraméthylène glycol de formule générale (I) :
- [O-CH₂-CH₂-CH₂-CH₂]ₙ (I)
avec n ≥ 25 ; et
avec une valeur minimale nₘᵢₙ pour la valeur n et une valeur maximale nₘₐₓ pour la valeur n dans la formule générale (I) ;
la différence entre nₘₐₓ et nₘᵢₙ allant de ≥ 0 à s 4 ;
les valeurs n, nₘₐₓ et nₘᵢₙ pouvant être identiques ou différentes pour le prépolymère de polyisocyanate B) d'une part et pour le composé contenant au moins deux groupes réactifs avec les isocyanates C) d'autre part lorsque le prépolymère de polyisocyanate B) et le composé contenant au moins deux groupes réactifs avec les isocyanates C) comprennent des unités éther de polytétraméthylène glycol de formule générale (I) ; et aucune unité éther de polytétraméthylène glycol supplémentaire en plus de celles de formule générale (I) n'étant présente dans le prépolymère de polyisocyanate B) et dans le composé contenant au moins deux groupes réactifs avec les isocyanates C), chacun considéré séparément ;
- la disposition de l'élastomère diélectrique entre la première électrode et la seconde électrode.

11. Procédé selon la revendication 10, dans lequel la préparation de l'élastomère diélectrique a lieu par application d'un mélange réactionnel conduisant au polymère de polyuréthane sur la première et/ou la seconde électrode.

12. Utilisation d'un élastomère diélectrique en tant qu'acteur, capteur et/ou générateur dans un convertisseur électromécanique, l'élastomère diélectrique comprenant un polymère de polyuréthane et le polymère de polyuréthane pouvant être obtenu par la réaction de
A) un polyisocyanate et/ou B) un prépolymère de polyisocyanate
avec C) un composé contenant au moins deux groupes réactifs avec les isocyanates ;
le prépolymère de polyisocyanate B) et/ou le composé contenant au moins deux groupes réactifs avec les isocyanates C) comprenant des unités éther de polytétraméthylène glycol de formule générale (I) :
- [O-CH₂-CH₂-CH₂-CH₂]ₙ (I)
avec n ≥ 25 ; et
avec une valeur minimale nₘᵢₙ pour la valeur n et une valeur maximale nₘₐₓ pour la valeur n dans la formule générale (I) ;
la différence entre nₘₐₓ et nₘᵢₙ allant de ≥ 0 à ≤ 4 ;
les valeurs n, nₘₐₓ et nₘᵢₙ pouvant être identiques ou différentes pour le prépolymère de polyisocyanate B) d'une part et pour le composé contenant au moins deux groupes réactifs avec les isocyanates C) d'autre part lorsque le prépolymère de polyisocyanate B) et le composé contenant au moins deux groupes réactifs avec les isocyanates C) comprennent des unités éther de polytétraméthylène glycol de formule générale (I) ; et aucune unité éther de polytétraméthylène glycol supplémentaire en plus de celles de formule générale (I) n'étant présente dans le prépolymère de polyisocyanate B) et dans le composé contenant au moins deux groupes réactifs avec les isocyanates C), chacun considéré séparément.

13. Dispositif électrique et/ou électronique, comprenant un convertisseur électromécanique selon la revendication 1.
